# EUROPÄISCHE PATENTSCHRIFT

(11) **EP 3 824 359 B1**
(45) Veröffentlichungstag und Bekanntmachung des Hinweises auf die Patenterteilung: **25.10.2023**
(21) Anmeldenummer: 19778861.5
(22) Anmeldetag: 17.09.2019
(51) Int. Cl.: G05B 19/048

(54) **PROJEKTIEREN, KONFIGURIEREN UND INSTANDHALTEN EINER ANTRIEBSVORRICHTUNG**
PROJECTING, CONFIGURING AND MAINTENANCE OF A DRIVE DEVICE
CONCEPTION, CONFIGURATION ET MAINTIEN D'UN DISPOSITIF D'ENTRAÎNEMENT

(30) Priorität: 28.09.2018 EP 18197453
(43) Veröffentlichungstag der Anmeldung: 26.05.2021
(73) Patentinhaber: Siemens Aktiengesellschaft, 80333 München (DE)
(72) Erfinder: HEGMANN, Michael, 91126 Schwabach (DE); LEIPOLD, Michael, 90491 Nürnberg (DE); KELLNER, Sven Ludwig, 91052 Erlangen (DE)
(74) Vertreter: Siemens Patent Attorneys
(86) Internationale Anmeldenummer: PCT/EP2019/074789
(87) Internationale Veröffentlichungsnummer: WO 2020/064412

(56) Entgegenhaltungen:
- DE-A1-102006 021 048
- US-A1- 2014 018 976
- US-A1- 2014 207 726

## Beschreibung

Die Erfindung betrifft ein Verfahren zum Projektieren, Konfigurieren und Instandhalten einer Antriebsvorrichtung.

Der Lebenszyklus einer Antriebsvorrichtung umfasst verschiedene Lebenszyklusphasen, beispielsweise einen Regelbetrieb mit einer aktuellen Konfiguration der Antriebsvorrichtung, Instandhaltungsmaßnahmen zur Wartung, Pflege und Reparatur, Konfigurationsänderungen und eine Inbetriebnahme der Antriebsvorrichtung. Derartige Lebenszyklusphasen können sich überlappen und wiederholen. Beispielsweise werden Wartungs-und Pflegemaßnahmen in der Regel wiederholt ausgeführt und Reparaturmaßnahmen können mehrfach erforderlich sein. Auch Konfigurationsänderungen können wiederholt erfolgen. Unter einer Konfigurationsänderung einer Antriebsvorrichtung wird hier eine Änderung der Parametrierung und/oder der Komponenten der Antriebsvorrichtung verstanden. Beispielsweise kann eine Konfigurationsänderung gewollt vorgenommen werden, um die Antriebsvorrichtung an geänderte Anforderungen anzupassen. Eine Konfigurationsänderung kann jedoch auch ungewollt, beispielsweise bei einer Instandhaltungsmaßnahme oder durch einen Hackerangriff, erfolgen. Auch eine Inbetriebnahme der Antriebsvorrichtung kann mehrfach erforderlich sein, beispielsweise kann neben einer Erstinbetriebnahme eine Inbetriebnahme nach einer Konfigurationsänderung oder Instandhaltungsmaßnahme notwendig sein.

Häufig werden in einer Lebenszyklusphase Informationen über eine vorangegangene Lebenszyklusphase benötigt. Beispielsweise ist es nach Konfigurationsänderungen oft wichtig festzustellen, welche Parameter und/oder Komponenten der Antriebsvorrichtung gegenüber einer vorherigen Konfiguration geändert wurden. Konfigurationsänderungen können ferner die Fragen aufwerfen, ob sie möglicherweise zu einer Fehlkonfiguration führen.

US 2014/207726 A1 offenbart ein System und ein Verfahren zum Warten von Hubschraubertriebwerken in Abhängigkeit vom technischen Zustand der Triebwerke und dem Austausch von Teilen. Dabei werden Daten über Betriebszustände und Betriebszustandsindikatoren, Änderungen der Triebwerke, Wartungen der Triebwerke, Wartungspläne für die Triebwerke, Ursachen ungeplanter Ereignisse und Konfigurationen in einer zentralisierten Datenbank gespeichert.

US 2014/018976 A1 offenbart ein Verfahren zum Erzeugen von Berichten, die einem unbemannten System zugeordnet sind, das über eine Fernsteuerungsstation gesteuert wird. Dabei werden Daten, die sich auf das unbemannte System beziehen, an die Fernsteuerungsstation übertragen, und in der Fernsteuerungsstation werden unter Verwendung der Daten mehrere Berichte erzeugt, die dem unbemannten System zugeordnet sind.

Der Erfindung liegt die Aufgabe zugrunde, ein verbessertes Verfahren zum Projektieren, Konfigurieren und Instandhalten einer Antriebsvorrichtung anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Bei dem erfindungsgemäßen Verfahren zum Projektieren, Konfigurieren und Instandhalten einer Antriebsvorrichtung wird für zum Projektieren, Konfigurieren und Instandhalten der Antriebsvorrichtung verwendete Anwendungsprogramme eine zentrale Datenbasis bereitgestellt, in der Daten mit einer temporalen Datenhaltung gespeichert werden und von den Anwendungsprogrammen gelesen und ergänzt werden können. Die die Antriebsvorrichtung umfasst beispielsweise einen Elektromotor und einen den Elektromotor antreibenden Frequenzumrichter. Unter das Konfigurieren einer Antriebsvorrichtung werden hier ein Aufbau der Antriebsvorrichtung aus bestimmten Komponenten und/oder eine Parametrierung der Antriebsvorrichtung gefasst. Unter das Instandhalten einer Antriebsvorrichtung werden Wartung, Pflege und Reparatur einschließlich eines Austausches von Komponenten gefasst.

Die Erfindung sieht also vor, zum Projektieren, Konfigurieren und Instandhalten einer Antriebsvorrichtung benötigte Daten in einer zentralen Datenbasis zu sammeln, auf die von zum Projektieren, Konfigurieren und Instandhalten der Antriebsvorrichtung verwendete Anwendungsprogramme zugreifen können, um Daten zu lesen und zu ergänzen. Dadurch werden die von den einzelnen Anwendungsprogrammen benötigten und erzeugten Informationen zentral verwaltet und brauchen nicht zwischen den einzelnen Anwendungsprogrammen ausgetauscht werden. Insbesondere entfällt eine fehleranfällige und zeitaufwändige Verwaltung und Synchronisation der Daten an unterschiedlichen Speicherorten. Durch die Verfügbarkeit aller Daten in der zentralen Datenbasis können außerdem die Inbetriebnahme der Antriebsvorrichtung und die Stillstandzeiten bei Störungen verkürzt werden, da diese Daten nicht aus unterschiedlichen Quellen besorgt oder erst erzeugt werden müssen.

Durch die temporale Datenhaltung der Daten in der zentralen Datenbasis werden die Daten jeweils mit einem den Zeitpunkt der Speicherung angebenden Zeitstempel gespeichert, ohne die vorher gespeicherten Daten zu löschen oder zu überschreiben. Dadurch kann ein Verlauf von an der Antriebsvorrichtung vorgenommenen Änderungen und Instandhaltungsmaßnahmen zurückverfolgt werden. Insbesondere kann beispielsweise bei einer Fehlkonfiguration der Antriebsvorrichtung einfacher eine Ursache der Fehlkonfiguration ermittelt werden und es kann gegebenenfalls auf eine ältere fehlerfreie Konfiguration der Antriebsvorrichtung zurückgegriffen werden, deren Daten in der zentralen Datenbasis abgelegt sind.

Eine Ausgestaltung der Erfindung sieht vor, dass in der zentralen Datenbasis eine Projektierung der Antriebsvorrichtung beschreibende Daten, jede realisierte Konfiguration der Antriebsvorrichtung beschreibende Daten und jede an der Antriebsvorrichtung vorgenommene Instandhaltungsmaßnahme beschreibende Daten gespeichert werden. Dadurch ermöglicht die zentrale Datenbasis eine Dokumentation der Projektierung und aller Konfigurationen und Konfigurationsänderungen der Antriebsvorrichtung sowie aller an der Antriebsvorrichtung vorgenommenen Instandhaltungsmaßnahmen in deren zeitlicher Abfolge.

Eine weitere Ausgestaltung der Erfindung sieht vor, dass den Betrieb und Betriebsbedingungen der Antriebsvorrichtung beschreibende Daten erfasst und aufbereitet werden und die aufbereiteten Daten in der Datenbasis gespeichert werden. Dies ermöglicht die Erfassung und Verwendung wichtiger Betriebsdaten der Antriebsvorrichtung, beispielsweise um zu beurteilen, ob die Konfiguration der Antriebsvorrichtung den Betriebsdaten angepasst ist oder geändert werden soll und wie die Konfiguration gegebenenfalls geändert werden sollte. Insbesondere kann die Konfiguration an geänderte Betriebsdaten angepasst werden, beispielsweise an eine geänderte Auslastung oder eine geänderte Umgebungstemperatur der Antriebsvorrichtung. Außerdem können im Betrieb der Antriebsvorrichtung auftretende Fehlfunktionen einfacher erkannt und gegebenenfalls behoben werden.

Eine weitere Ausgestaltung der Erfindung sieht vor, dass Daten manuell in die zentrale Datenbasis eingegeben werden können. Dies ermöglicht es beispielsweise, an der Antriebsvorrichtung manuell vorgenommene Änderungen oder Instandhaltungsmaßnahmen in der zentralen Datenbasis zu speichern.

Eine weitere Ausgestaltung der Erfindung sieht vor, dass die zentrale Datenbasis auf einem Server eines Intranets oder über ein Rechnernetz in einer Datenwolke bereitgestellt wird. Die Bereitstellung der zentralen Datenbasis auf einem Server eines Intranets kann vorteilhaft sein, wenn alle auf die zentrale Datenbasis zugreifenden Programme und Benutzer Zugang zu dem Intranet haben. Die Bereitstellung der zentralen Datenbasis über ein Rechnernetz in einer Datenwolke kann vorteilhaft sein, wenn die Zugriffsmöglichkeiten auf die zentrale Datenbasis flexibel gestaltet werden sollen.

Eine weitere Ausgestaltung der Erfindung sieht vor, dass zu vorgegebenen Zeitpunkten in der zentralen Datenbasis Daten gespeichert werden, die eine jeweils aktuelle Konfiguration der Antriebsvorrichtung beschreiben. Dadurch kann vorteilhaft erreicht werden, dass über die zentrale Datenbasis möglichst die jeweils aktuelle Konfiguration der Antriebsvorrichtung abrufbar ist, auch wenn beispielsweise die Speicherung von eine Konfigurationsänderung beschreibenden Daten in der zentralen Datenbasis versäumt wurde oder fehlgeschlagen ist.

Die Erfindung sieht auch vor, dass Konfigurationsregeln für eine Durchführung und/oder ein Ausmaß einer Konfigurationsänderung der Konfiguration der Antriebsvorrichtung definiert werden, wobei die Konfigurationsregeln von einer Lebenzyklusphase der Antriebsvorrichtung abhängen. Vorzugsweise wird ferner überwacht, ob die Konfigurationsregeln bei der Konfigurationsänderung der Konfiguration der Antriebsvorrichtung eingehalten werden, und es wird eine Warnung generiert, wenn die Konfigurationsregeln nicht eingehalten werden. Durch die Definition geeigneter Konfigurationsregeln kann die Durchführung von Konfigurationsänderungen organisiert und unkoordinierte Konfigurationsänderungen, beispielsweise von verschiedenen Benutzern und/oder Anwendungsprogrammen, vermieden werden. Durch die Abhängigkeit der Konfigurationsregeln von einer Lebenzyklusphase der Antriebsvorrichtung können spezielle Anforderungen der verschiedenen Lebenzyklusphasen berücksichtigt werden. Beispielsweise kann zugelassen werden, dass bei einer Inbetriebnahme Sicherheitsvorgaben deaktiviert werden dürfen, die in einem Regelbetrieb der Antriebsvorrichtung aktiviert sein müssen. Durch die Ausgabe einer Warnung bei einer Verletzung der Konfigurationsregeln kann auf eine potentielle Fehlkonfiguration durch die Verletzung der Konfigurationsregeln hingewiesen und eine Fehlkonfiguration gegebenenfalls verhindert werden.

Eine weitere Ausgestaltung der Erfindung sieht vor, dass typische Konfigurationsänderungen einer Konfiguration der Antriebsvorrichtung ermittelt und/oder definiert werden, überwacht wird, ob die Konfigurationsänderung der Konfiguration der Antriebsvorrichtung eine typische Konfigurationsänderung ist, und eine Warnung generiert wird, wenn eine Konfigurationsänderung der Konfiguration der Antriebsvorrichtung keine typische Konfigurationsänderung ist. Untypische Konfigurationsänderungen können Fehlkonfigurationen signalisieren, beispielsweise auch durch Hackerangriffe böswillig verursachte Fehlkonfigurationen. Daher können Fehlkonfigurationen durch die Erkennung untypischer Konfigurationsänderungen und die Ausgabe einer Warnung im Falle einer erkannten untypischen Konfigurationsänderung gegebenenfalls vermieden werden.

Die Erfindung sieht vor, dass ein Simulationsprogramm bereitgestellt wird, von dem die in der Datenbasis gespeicherten Daten gelesen und für eine Antriebssimulation der Antriebsvorrichtung und deren Betrieb verwendet werden. Vorzugsweise ermöglicht die Antriebssimulation eine Simulation einer vollständigen Parametrierung der Antriebsvorrichtung und/oder eine Simulation eines Verhaltens der Antriebsvorrichtung in Fehlerfällen. Ferner kann das Simulationsprogramm eine Maschinensimulation einer die Antriebsvorrichtung aufweisenden Maschine durchführen und die Antriebssimulation kann in die Maschinensimulation integriert sein. Eine möglichst realistische Antriebssimulation der Antriebsvorrichtung und deren Betrieb ermöglicht vorteilhaft eine optimierte Projektierung und Konfiguration der Antriebsvorrichtung. Die vorgenannte Ausgestaltung der Erfindung ermöglicht eine realistische Antriebssimulation durch die Einbeziehung in der zentralen Datenbasis gespeicherter Daten in die Antriebssimulation. Eine Integration der Antriebssimulation in eine Maschinensimulation einer die Antriebsvorrichtung aufweisenden Maschine ermöglicht eine besonders realistische Simulation der Antriebsvorrichtung und deren Betrieb und ist deshalb besonders bevorzugt.

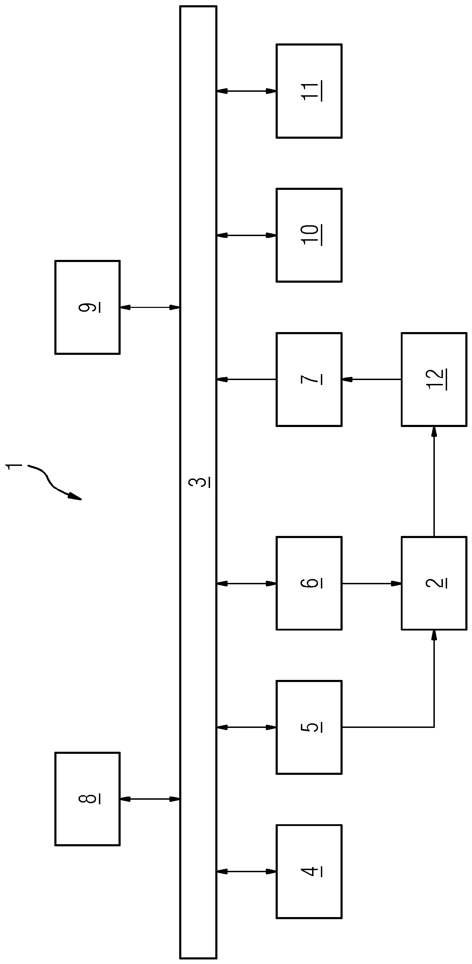

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit der Zeichnung näher erläutert werden. Dabei zeigt die einzige Figur ein Blockdiagramm eines Systems 1 zum Projektieren, Konfigurieren und Instandhalten einer Antriebsvorrichtung 2.

Das System 1 umfasst eine zentrale Datenbasis 3, auf die Datenbasis 3 zugreifende Anwendungsprogramme 4 bis 7, Serviceprogramme 8, 9, eine Benutzerschnittstelle 10 und ein Simulationsprogramm 11.

Die Antriebsvorrichtung 2 umfasst beispielsweise einen Elektromotor und einen den Elektromotor antreibenden Frequenzumrichter sowie gegebenenfalls ein Getriebe und eine Kupplung.

Die zentrale Datenbasis 3 wird beispielsweise auf einem Server eines Intranets oder über ein Rechnernetz in einer Datenwolke bereitgestellt.

In der zentralen Datenbasis 3 werden eine Projektierung der Antriebsvorrichtung 2, jede realisierte Konfiguration der Antriebsvorrichtung 2 und jede an der Antriebsvorrichtung 2 vorgenommene Instandhaltungsmaßnahme beschreibende Daten gespeichert. Ferner werden in der zentralen Datenbasis 3 den Betrieb und Betriebsbedingungen der Antriebsvorrichtung 2 beschreibende Daten gespeichert.

In dem in Figur dargestellten Beispiel werden die eine Projektierung der Antriebsvorrichtung 2 beschreibenden Daten mittels eines ersten Anwendungsprogramms 4 erzeugt und in die zentrale Datenbasis 3 geschrieben. Diese Daten beschreiben insbesondere eine Dimensionierung und Auslegung der Antriebsvorrichtung 2, beispielsweise Leistungs- und Drehzahlbereiche des Elektromotors.

Die eine Konfiguration der Antriebsvorrichtung 2 beschreibenden Daten werden mittels eines zweiten Anwendungsprogramms 5 erzeugt und in die zentrale Datenbasis 3 geschrieben. Diese Daten beschreiben insbesondere eine Parametrierung und die Komponenten der Antriebsvorrichtung 2, beispielsweise auch Bestellnummern dieser Komponenten.

An der Antriebsvorrichtung 2 vorgenommene Instandhaltungsmaßnahmen beschreibende Daten werden unter anderem mittels eines dritten Anwendungsprogramms 6 erzeugt und in die zentrale Datenbasis 3 geschrieben. Diese Daten beschreiben insbesondere Wartungs-, Pflege-, Austausch- und Reparaturmaßnahmen, die automatisiert von dem dritten Anwendungsprogramm 6 oder unter Verwendung des dritten Anwendungsprogramms 6 durchgeführt werden, beispielsweise in Form von die Instandhaltungsmaßnahmen beschreibenden Protokolldateien (Logdateien).

Über die Benutzerschnittstelle 10 können Benutzer auf die zentrale Datenbasis 3 zugreifen, um in der zentralen Datenbasis 3 gespeicherte Daten zu lesen und/oder Daten manuell in die zentrale Datenbasis 3 einzugeben. Dazu werden beispielsweise Zugriffsrechte vergeben, die festlegen, welche Benutzer Daten lesen und/oder eingeben dürfen. Beispielsweise können über die Benutzerschnittstelle 10 Daten eingegeben werden, die an der Antriebsvorrichtung 2 manuell vorgenommene Instandhaltungsmaßnahmen wie Wartungs-, Pflege-, Austausch- und Reparaturmaßnahmen beschreiben.

Die den Betrieb und Betriebsbedingungen der Antriebsvorrichtung 2 beschreibenden Daten werden mittels eines vierten Anwendungsprogramms 7 erzeugt und in die zentrale Datenbasis 3 geschrieben. Diese Daten beschreiben beispielsweise eine Auslastung und im Betrieb auftretende Fehler der Antriebsvorrichtung 2 sowie Betriebsbedingungen wie eine Temperatur oder Luftfeuchtigkeit. Diese Daten werden aus von einer Messvorrichtung 12 erfassten Messdaten erzeugt, dem vierten Anwendungsprogramm 7 zugeführt und von dem vierten Anwendungsprogramm 7 aufbereitet. Die aufbereiteten Messdaten werden von dem vierten Anwendungsprogramm 7 in die zentrale Datenbasis 3 geschrieben.

Ferner kann von dem Simulationsprogramm 11 auf die in der zentralen Datenbasis 3 gespeicherten Daten zugegriffen werden, um die Daten für eine Antriebssimulation der Antriebsvorrichtung 2 und deren Betrieb zu verwenden. Die Antriebssimulation ermöglicht eine Simulation einer vollständigen Parametrierung der Antriebsvorrichtung 2, beispielsweise des Verhaltens von Ein- und Ausgängen, eines Sollwertkanals, von Sicherheitsfunktionen, von Technologiereglern, eines Einfachpositionierers zum Positionieren einer Motorachse, eines Drehzahlreglers des Elektromotors, von logischen Verknüpfungen und einer Systemeinbindung (beispielsweise einer Kommunikation mit einer Steuerung) der Antriebsvorrichtung 2. Insbesondere ermöglicht die Antriebssimulation eine Simulation eines Verhaltens der Antriebsvorrichtung 2 in Fehlerfällen. Vorzugsweise ist das Simulationsprogramm 11 dazu ausgebildet, eine Maschinensimulation einer die Antriebsvorrichtung 2 aufweisenden Maschine durchzuführen, wobei die Antriebssimulation in die Maschinensimulation integriert ist. Die Integration der Antriebssimulation in die Maschinensimulation kann beispielsweise ermöglichen, Teile der Konfiguration der Antriebsvorrichtung 2 (beispielsweise Einstellungen von Regelungsparametern) als ein Ergebnis der Simulation automatisch zu generieren und automatisch weiter zu optimieren. Das Simulationsprogramm 11 wird beispielsweise auf einem Personal Computer ausgeführt.

Die Serviceprogramme 8, 9 ermöglichen einem Antriebshersteller der Antriebsvorrichtung 2, auf die zentrale Datenbasis 3 zuzugreifen, um in der zentralen Datenbasis 3 gespeicherte Daten zu lesen und zu ergänzen. Beispielsweise ermöglicht ein erstes Serviceprogramm 8 dem Antriebshersteller, Daten zur Produktfreigabe, Produktpflege und Produkthandhabung (beispielsweise Handbücher) in der zentralen Datenbasis 3 bereitzustellen, und ein zweites Serviceprogramm 9 ermöglicht eine Initiierung und Dokumentation einer Rückwarenabwicklung, beispielsweise um Komponenten der Antriebsvorrichtung 2 auszutauschen.

Die Daten werden in der zentralen Datenbasis 3 mit einer temporalen Datenhaltung gespeichert. Mit anderen Worten werden die Daten mit einem Zeitstempel gespeichert, der jeweils einen Zeitpunkt der Speicherung der Daten angibt, wobei vorher gespeicherte Daten weder gelöscht noch überschrieben werden. Ferner können die Daten zusätzlich mit einer Kennung des die Datenspeicherung jeweils veranlassenden Programms oder Benutzers gespeichert werden.

Es kann ferner vorgesehen sein, zu vorgegebenen Zeitpunkten, insbesondere in regelmäßigen zeitlichen Abständen, in der zentralen Datenbasis 3 Daten zu speichern, die eine jeweils aktuelle Konfiguration der Antriebsvorrichtung 2 beschreiben. Dadurch kann vorteilhaft erreicht werden, dass über die zentrale Datenbasis 3 möglichst die jeweils aktuelle Konfiguration der Antriebsvorrichtung 2 abrufbar ist, auch wenn beispielsweise die Speicherung von eine Konfigurationsänderung beschreibenden Daten in der zentralen Datenbasis 3 versäumt wurde oder fehlgeschlagen ist. Bei der Speicherung einer aktuellen Konfiguration können beispielsweise Parameter ausgenommen werden, die regelmäßig geändert werden (beispielsweise ein regelmäßig geänderter Sollwert).

Ferner kann vorgesehen sein, dass Konfigurationsregeln für eine Durchführung und/oder ein Ausmaß einer Konfigurationsänderung der Konfiguration der Antriebsvorrichtung 2 definiert werden. Beispielsweise kann in der Datenbasis 3 wenigstens eine Konfigurationseinschränkung für eine Konfiguration der Antriebsvorrichtung 2 definiert werden, beispielsweise indem für wenigstens einen konfigurierbaren Parameter der Antriebsvorrichtung 2 ein Wertebereich für zulässige Werte des Parameters definiert wird. Ferner können die Konfigurationsregeln beispielsweise ein gleichzeitiges Ändern verschiedener Konfigurationsparameter einschränken und/oder eine Reihenfolge von Konfigurationsänderungen festlegen, um die Durchführung von Konfigurationsänderungen zu organisieren und unkoordinierte Konfigurationsänderungen, beispielsweise von verschiedenen Benutzern und/oder Anwendungsprogrammen 4 bis 6, zu vermeiden.

Die Konfigurationsregeln können ferner von einer Lebenzyklusphase der Antriebsvorrichtung 2 abhängig gemacht werden. Beispielsweise kann zugelassen sein, dass bei einer Inbetriebnahme Sicherheitsvorgaben deaktiviert werden dürfen, die in einem Regelbetrieb der Antriebsvorrichtung 2 aktiviert sein müssen.

Des Weiteren wird vorzugsweise überwacht, ob die Konfigurationsregeln bei einer Konfigurationsänderung der Konfiguration der Antriebsvorrichtung 2 eingehalten werden, und es wird eine Warnung generiert, wenn die Konfigurationsregeln nicht eingehalten werden. Die Überwachung der Einhaltung der Konfigurationsregeln und die Generierung einer Warnung können in der zentralen Datenbasis 3 implementiert sein, das heißt von der zentralen Datenbasis 3 ausgeführt werden.

Ferner können typische Konfigurationsänderungen der Konfiguration der Antriebsvorrichtung 2 ermittelt und/oder definiert werden, und es kann überwacht werden, ob eine Konfigurationsänderung der Konfiguration der Antriebsvorrichtung 2 eine typische Konfigurationsänderung ist. Wenn eine Konfigurationsänderung der Konfiguration der Antriebsvorrichtung 2 keine typische Konfigurationsänderung ist, kann eine Warnung generiert werden. Typische Konfigurationsänderungen können beispielsweise durch einen Vergleich mit bisherigen Konfigurationsänderungen, vorgegebenen Beispielkonfigurationen und/oder bekannten Standardkonfigurationen (beispielsweise von gleichen Antriebsvorrichtungen 2 in gleichen Maschinen) und/oder durch eine fachliche Konfigurationsanalyse (beispielsweise auch mit Hilfe von Selbstlernmechanismen) ermittelt und/oder definiert werden. Durch das Ausgeben einer Warnung bei einer untypischen Konfigurationsänderung kann auf mögliche Konfigurationsfehler, beispielsweise auch durch Hackerangriffe, hingewiesen werden. Auch diese Überwachung von Konfigurationsänderungen und das Ausgeben von Warnungen können in der zentralen Datenbasis 3 implementiert sein, das heißt von der zentralen Datenbasis 3 ausgeführt werden.

Um Warnungen auszugeben, weist die zentrale Datenbasis 3 beispielsweise eine Benachrichtigungsschnittstelle auf, über die die Warnungen einem Betreiber der Antriebsvorrichtung 2 übermittelt werden. Ferner kann die zentrale Datenbasis 3 eine Datenschnittstelle zu einer anderen Datenbasis aufweisen, über die Daten mit der anderen Datenbasis ausgetauscht werden können, beispielsweise um Beispiel- oder Standardkonfigurationen gleicher oder ähnlicher Antriebsvorrichtungen 2 abzurufen. Außerdem können in der zentralen Datenbasis 3 Daten zu mehreren Antriebsvorrichtungen 2 einer Maschine und/oder auch Antriebsvorrichtungen 2 verschiedener Maschinen gespeichert und verwaltet werden.

## Patentansprüche

1. Verfahren zum Projektieren, Konfigurieren und Instandhalten einer Antriebsvorrichtung (2), wobei für zum Projektieren, Konfigurieren und Instandhalten der Antriebsvorrichtung (2) verwendete Anwendungsprogramme (4 bis 7) eine zentrale Datenbasis (3) bereitgestellt wird, in der Daten mit einer temporalen Datenhaltung gespeichert werden und von den Anwendungsprogrammen (4 bis 7) lesbar und ergänzbar sind,
**dadurch gekennzeichnet, dass**
von einer Lebenzyklusphase der Antriebsvorrichtung (2) abhängende Konfigurationsregeln für eine Durchführung und/oder ein Ausmaß einer Konfigurationsänderung der Konfiguration der Antriebsvorrichtung (2) definiert werden und dass ein Simulationsprogramm (11) bereitgestellt wird, von dem die in der zentralen Datenbasis (3) gespeicherten Daten gelesen und für eine Antriebssimulation der Antriebsvorrichtung (2) und deren Betrieb verwendet werden.

2. Verfahren nach Anspruch 1, wobei die Antriebsvorrichtung (2) einen Elektromotor und einen den Elektromotor antreibenden Frequenzumrichter umfasst.

3. Verfahren nach Anspruch 1 oder 2, wobei in der zentralen Datenbasis (3) eine Projektierung der Antriebsvorrichtung (2) beschreibende Daten, jede realisierte Konfiguration der Antriebsvorrichtung (2) beschreibende Daten und jede an der Antriebsvorrichtung (2) vorgenommene Instandhaltungsmaßnahme beschreibende Daten gespeichert werden.

4. Verfahren nach einem der vorhergehenden Ansprüche, wobei den Betrieb und Betriebsbedingungen der Antriebsvorrichtung (2) beschreibende Daten erfasst und aufbereitet werden und die aufbereiteten Daten in der zentralen Datenbasis (3) gespeichert werden.

5. Verfahren nach einem der vorhergehenden Ansprüche, wobei Daten manuell in die zentrale Datenbasis (3) eingebbar sind.

6. Verfahren nach einem der vorhergehenden Ansprüche, wobei die zentrale Datenbasis (3) auf einem Server eines Intranets oder über ein Rechnernetz in einer Datenwolke bereitgestellt wird.

7. Verfahren nach einem der vorhergehenden Ansprüche, wobei zu vorgegebenen Zeitpunkten in der zentralen Datenbasis (3) Daten gespeichert werden, die eine jeweils aktuelle Konfiguration der Antriebsvorrichtung (2) beschreiben.

8. Verfahren nach einem der vorhergehenden Ansprüche, wobei überwacht wird, ob die Konfigurationsregeln bei der Konfigurationsänderung der Konfiguration der Antriebsvorrichtung (2) eingehalten werden, und eine Warnung generiert wird, wenn die Konfigurationsregeln nicht eingehalten werden.

9. Verfahren nach einem der vorhergehenden Ansprüche, wobei typische Konfigurationsänderungen einer Konfiguration der Antriebsvorrichtung (2) ermittelt und/oder definiert werden, überwacht wird, ob die Konfigurationsänderung der Konfiguration der Antriebsvorrichtung (2) eine typische Konfigurationsänderung ist, und eine Warnung generiert wird, wenn eine Konfigurationsänderung der Konfiguration der Antriebsvorrichtung (2) keine typische Konfigurationsänderung ist.

10. Verfahren nach einem der vorhergehenden Ansprüche, wobei die Antriebssimulation eine Simulation einer vollständigen Parametrierung der Antriebsvorrichtung (2) ermöglicht.

11. Verfahren nach Anspruch 10, wobei die Antriebssimulation eine Simulation eines Verhaltens der Antriebsvorrichtung (2) in Fehlerfällen ermöglicht.

12. Verfahren nach einem der Ansprüche 10 oder 11, wobei das Simulationsprogramm (11) eine Maschinensimulation einer die Antriebsvorrichtung (2) aufweisenden Maschine durchführt und die Antriebssimulation in die Maschinensimulation integriert ist.

## Claims

1. Method for designing, configuring and maintaining a drive device (2), wherein a central database (3) is provided for application programs (4 to 7) used for designing, configuring and maintaining the drive device (2), in which database data is stored as temporal data and can be read and supplemented by the application programs (4 to 7),
**characterised in that**
configuration rules, dependent on a life cycle phase of the drive device (2), for an execution and/or an extent of a configuration change to the configuration of the drive device (2) are defined and a simulation program (11) is provided from which the data stored in the central database (3) is read and used for a drive simulation of the drive device (2) and the operation thereof.

2. Method according to claim 1, wherein the drive device (2) comprises an electric motor and a frequency converter driving the electric motor.

3. Method according to claim 1 or 2, wherein data describing the designing of the drive device (2), data describing each implemented configuration of the drive device (2) and data describing each maintenance measure performed on the drive device (2) are stored in the central database (3).

4. Method according to one of the preceding claims, wherein data describing the operation and operating conditions of the drive device (2) is acquired and processed and the processed data is stored in the central database (3).

5. Method according to one of the preceding claims, wherein it is possible to enter data manually into the central database (3).

6. Method according to one of the preceding claims, wherein the central database (3) is provided on a server of an intranet or via a computer network in a data cloud.

7. Method according to one of the preceding claims, wherein data that describes the current configuration of the drive device (2) in each case is stored in the central database (3) at predetermined times.

8. Method according to one of the preceding claims, wherein it is monitored whether the configuration rules are complied with on a configuration change to the configuration of the drive device (2) and a warning is generated if the configuration rules are not complied with.

9. Method according to one of the preceding claims, wherein typical configuration changes to a configuration of the drive device (2) are determined and/or defined, it is monitored whether a configuration change to the configuration of the drive device (2) is a typical configuration change and a warning is generated if a configuration change to the configuration of the drive device (2) is not a typical configuration change.

10. Method according to one of the preceding claims, wherein the drive simulation enables simulation of a complete parameterisation of the drive device (2).

11. Method according to claim 10, wherein the drive simulation enables simulation of the behaviour of the drive device (2) in the event of faults.

12. Method according to one of claims 10 or 11, wherein the simulation program (11) executes a machine simulation of a machine with the drive device (2) and the drive simulation is integrated in the machine simulation.

## Revendications

1. Procédé de mise en projet, de configuration et d'entretien d'un dispositif (2) d'entraînement, dans lequel, pour des programmes (4 à 7) d'application utilisés pour la mise en projet, la configuration et l'entretien du dispositif (2) d'entraînement, il est mis à disposition une base (3) centrale de données, dans lequel on met en mémoire des données ayant un maintien temporel de données et, qui peuvent être déchiffrées et complétées par les programmes (4 à 7) d'application, **caractérisé en ce que**
on définit des règles de configuration, en fonction d'une phase de cycle de vie du dispositif (2) d'entraînement, pour une réalisation et/ou une mesure d'une modification de la configuration du dispositif (2) d'entraînement et **en ce qu'**on met à disposition un programme (11) de simulation par lequel on déchiffre les données mises en mémoire dans la base (3) centrale de données et on les utilise pour une simulation d'entraînement du dispositif (2) d'entraînement et de son fonctionnement.

2. Procédé suivant la revendication 1, dans lequel le dispositif (2) d'entraînement est un moteur électrique et comprend un convertisseur de fréquence entraînant le moteur électrique.

3. Procédé suivant la revendication 1 ou 2, dans lequel on met en mémoire dans la base (3) centrale de données des données décrivant une mise en projet du dispositif (2) d'entraînement, des données décrivant chaque configuration réalisée du dispositif (2) d'entraînement et des données décrivant chaque mesure d'entretien effectuée sur le dispositif (2) d'entraînement.

4. Procédé suivant l'une des revendications précédentes, dans lequel on détecte et on traite des données décrivant le fonctionnement et les conditions de fonctionnement du dispositif (2) d'entraînement et on met en mémoire les données traitées dans la base (3) centrale de données.

5. Procédé suivant l'une des revendications précédentes, dans lequel des données peuvent être entrées manuellement dans la base (3) centrale de données.

6. Procédé suivant l'une des revendications précédentes, dans lequel on met la base (3) centrale de données à disposition sur un serveur d'un intranet ou par un réseau informatique dans un nuage de données.

7. Procédé suivant l'une des revendications précédentes, dans lequel on met en mémoire à des instants donnés à l'avance, dans la base (3) centrale de données, des données qui décrivent une configuration en cours respective du dispositif (2) d'entraînement.

8. Procédé suivant l'une des revendications précédentes, dans lequel on contrôle si les règles de configuration sont respectées lors de la modification de la configuration du dispositif (2) d'entraînement et on produit une alerte si les règles de configuration ne sont pas respectées.

9. Procédé suivant l'une des revendications précédentes, dans lequel on détermine et/ou définit des modifications typiques d'une configuration du dispositif (2) d'entraînement, on contrôle si la modification de la configuration du dispositif (2) d'entraînement est une modification typique de configuration et on produit une alerte si une modification de la configuration du dispositif (2) d'entraînement n'est pas une modification typique de configuration.

10. Procédé suivant l'une des revendications précédentes, dans lequel la simulation d'entraînement rend possible une simulation d'un paramétrage complet du dispositif (2) d'entraînement.

11. Procédé suivant la revendication 10, dans lequel la simulation d'entraînement rend possible une simulation d'un comportement du dispositif (2) d'entraînement dans des cas de défaillance.

12. Procédé suivant l'une des revendications 10 ou 11, dans lequel le programme (11) de simulation effectue une simulation d'une machine ayant le dispositif (2) d'entraînement et la simulation d'entraînement est intégrée dans la simulation de la machine.
